# EUROPEAN PATENT APPLICATION

(11) **EP 4 425 190 A1**
(43) Date of publication of application: **04.09.2024**
(21) Application number: 22886532.5
(22) Date of filing: 21.09.2022
(51) Int. Cl.: G01R 1/073, G01R 1/067, H05K 1/02

(54) **FLEXIBLE SUBSTRATE AND TESTING JIG**

(30) Priority: 27.10.2021 JP 2021175149
(71) Applicant: Yokowo Co., Ltd., Tokyo 101-0041 (JP)
(72) Inventor: MIURA, Chikara, Tokyo 114-8515 (JP); SUZUKI, Hisashi, Tokyo 114-8515 (JP)
(74) Representative: Gunzelmann, Rainer
(86) International application number: PCT/JP2022/035065
(87) International publication number: WO 2023/074198

(57) **Abstract**

Provided is a flexible substrate that does not easily break even if force is imparted to a portion thereof, and the like. The flexible substrate comprises one end, another end, and a pattern part 31a3 formed at least between the one end and the other end. The pattern part 31a3 has a first tongue 31a41 formed by notching. The first tongue 31a41 includes a first region A1 which is the tip region of the first tongue 3 1a41, and a second region A2 which is connected with the first region A1 and which is the base region of the first tongue 31a41. The first tongue 31a41 is electrically connected with another member via the first region A1. The width of the first region A1 of the first tongue 31a41 is wider than the width of the second region A2 of the first tongue 31a41.

## Description

### TECHNICAL FIELD

The present invention relates to a flexible substrate and the like.

### BACKGROUND ART

In the related art, as disclosed in Patent Literature 1, a flexible substrate that is extendable has been proposed.

### CITATION LIST

### PATENT LITERATURE

Patent Literature 1: JP2020-92277A

### SUMMARY OF INVENTION

### TECHNICAL PROBLEM

However, when a force is partially applied to the flexible substrate, a part of the flexible substrate may be bent or otherwise damaged.

Therefore, an example of an object of the present invention is to provide a flexible substrate or the like which is not easily damaged even when a force is partially applied. Another object of the present invention becomes apparent from description of this specification.

### SOLUTION TO PROBLEM

A flexible substrate according to the present invention includes one end portion, the other end portion, and a pattern portion formed at least between the one end portion and the other end portion. The pattern portion includes a first tongue piece formed by a notch. The first tongue piece includes a first region which is a distal end region of the first tongue piece and a second region which is a base region of the first tongue piece and communicates with the first region. The first tongue piece is electrically connected to another member via the first region. A width of the first region is larger than a width of the second region.

As described above, according to the present invention, it is possible to provide a flexible substrate or the like which is not easily damaged even when a force is partially applied.

### BRIEF DESCRIPTION OF DRAWINGS

[FIG. 1] FIG. 1 is an exploded perspective view of a first inspection jig according to a first embodiment;
[FIG. 2] FIG. 2 is an exploded perspective view of a connector contact portion, a substrate holding portion, and a substrate portion;
[FIG. 3] FIG. 3 is an exploded perspective view of a front-side substrate assembly;
[FIG. 4] FIG. 4 is a perspective view of a first flexible substrate as viewed from a front side and a lower side;
[FIG. 5] FIG. 5 is a perspective view of a region of the first flexible substrate in which tongue pieces are present, as viewed from the front side and the lower side;
[FIG. 6] FIG. 6 is a view of the region of the first flexible substrate in which the tongue pieces are present, as viewed from below;
[FIG. 7] FIG. 7 is an exploded perspective view of an assembly of the first flexible substrate and a first connector, a front-side holding portion, a front-side connector base, and a front-side probe group;
[FIG. 8] FIG. 8 is an exploded perspective view of a rear-side substrate assembly;
[FIG. 9] FIG. 9 is a perspective view of the first inspection jig as viewed from the front side and the lower side;
[FIG. 10] FIG. 10 is a front view of the first inspection jig as viewed from the front side;
[FIG. 11] FIG. 11 is a yz cross-sectional configuration view of the first inspection jig and the inspection target connector in a first state, including the region where first springs are present;
[FIG. 12] FIG. 12 is an xz cross-sectional configuration view in which a region where the tongue pieces of the first flexible substrate in the first state are present is enlarged;
[FIG. 13] FIG. 13 is a yz cross-sectional configuration view of the first inspection jig and the inspection target connector in a second state, including the region where the first springs are present;
[FIG. 14] FIG. 14 is a yz cross-sectional configuration view of the first inspection jig and the inspection target connector in a third state, including the region where the first springs are present;
[FIG. 15] FIG. 15 is a yz cross-sectional configuration view of the first inspection jig and the inspection target connector in a fourth state, including the region where the first springs are present;
[FIG. 16] FIG. 16 is an xz cross-sectional configuration view in which a region where the tongue pieces of the first flexible substrate in the fourth state are present is enlarged;
[FIG. 17] FIG. 17 is a yz cross-sectional configuration view of the first inspection jig and the inspection target connector in a fifth state, including the region where the first springs are present;
[FIG. 18] FIG. 18 is a perspective view of a second inspection jig according to a second embodiment;
[FIG. 19] FIG. 19 is a cross-sectional view of the second inspection jig;
[FIG. 20] FIG. 20 is a perspective view of a first flexible substrate according to the second embodiment;
[FIG. 21] FIG. 21 is a perspective view of a third inspection jig according to a third embodiment;
[FIG. 22] FIG. 22 is a perspective view of a first flexible substrate according to the third embodiment;
[FIG. 23] FIG. 23 is a perspective view of a fourth inspection jig according to a fourth embodiment;
[FIG. 24] FIG. 24 is a perspective view of the first flexible substrate to tenth flexible substrate of the fourth embodiment; and
[FIG. 25] FIG. 25 is an enlarged perspective view of a region in FIG. 24 where first tongue pieces and second tongue pieces of the first flexible substrate are present.

### DESCRIPTION OF EMBODIMENTS

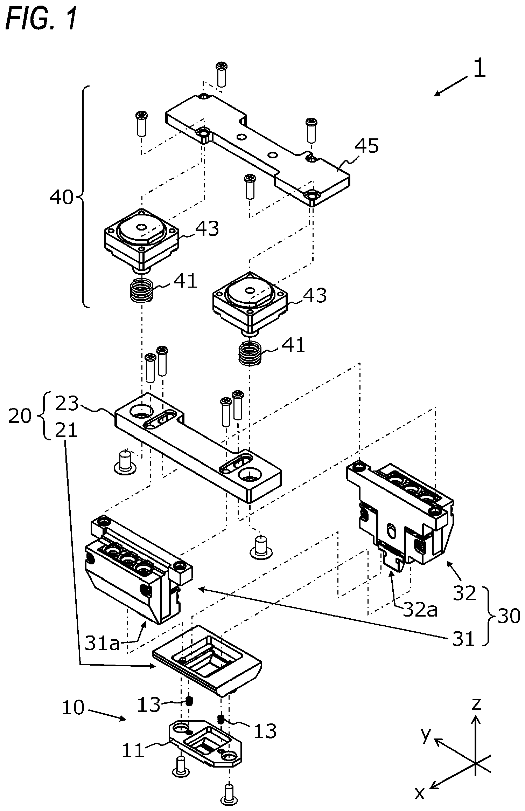

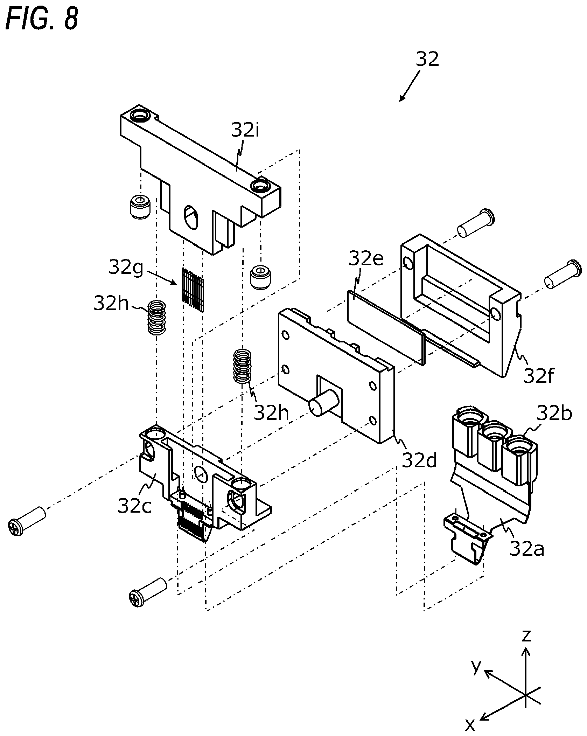

Hereinafter, a first embodiment will be described with reference to FIGS. 1 to 17. Embodiments are not limited to the following embodiments. Further, contents described in one embodiment are similarly applied to other embodiments in principle. Further, the embodiments and modifications can be appropriately combined.

### First Inspection Jig 1

As illustrated in FIG. 1, a first inspection jig 1 in the first embodiment includes a connector contact portion 10, a substrate holding portion 20, a substrate portion 30, and a horizontal position adjusting portion 40. The first inspection jig 1 is brought into contact with an inspection target connector (B to B connector: Board to Board connector) 100 to be inspected via the connector contact portion 10, and is electrically connected to a first flexible substrate 31a and a second flexible substrate 32a inside. In FIG. 1, the inspection target connector 100 is not illustrated.

In order to describe directions, a horizontal direction (front-rear direction) in which two substrate assemblies (front-side substrate assembly 31 and rear-side substrate assembly 32) are arranged is referred to as an x direction, a direction (left-right direction) that is perpendicular to the x direction and has two support portions 43 arranged therein is referred to as a y direction, and a direction (up-down direction) perpendicular to the x direction and the y direction is referred to as a z direction. In FIG. 1, directions indicated by respective arrows of xyz axes are defined as a forward direction, a rightward direction, and an upward direction, respectively. Specifically, a direction from the rear-side substrate assembly 32 toward the front-side substrate assembly 31 is defined as the forward direction. In addition, of the two support portions 43, a direction from the support portion 43 positioned at the lower right in FIG. 1 to the support portion 43 positioned at the upper left in FIG. 1 is defined as the rightward direction. Further, a direction from the connector contact portion 10 toward the horizontal position adjusting portion 40 is defined as the upward direction.

### Connector Contact Portion 10

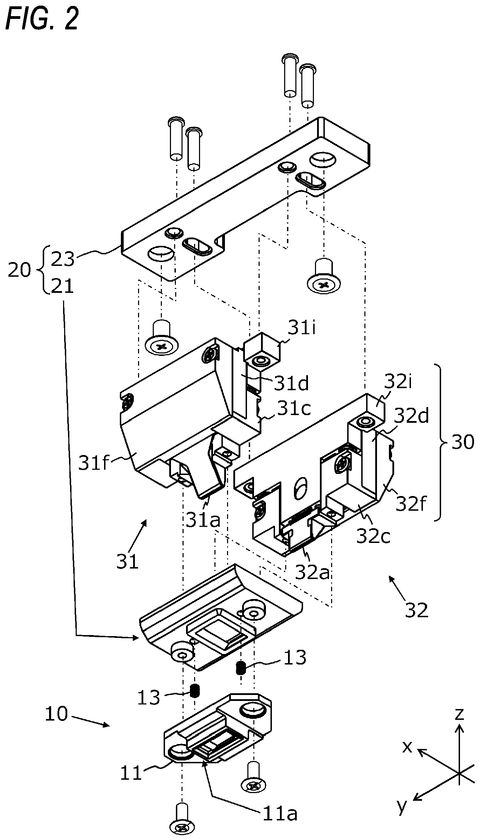

As illustrated in FIG. 2, the connector contact portion 10 includes a floating guide (first movable member) 11 and first springs (first elastic members) 13. The floating guide 11 has a hole penetrating in the z direction. A lower end of a lower-side holding portion 21 and a lower end of the substrate portion 30 are inserted into the hole of the floating guide 11 from an upper side in the z direction. An upper end of the inspection target connector 100 is inserted into the hole of the floating guide 11 from a lower side in the z direction. That is, the inspection target connector 100 is attached to the floating guide 11 in a detachable state.

In order to facilitate insertion of the inspection target connector 100, it is desirable that a guide portion 11a having an inclined shape in which an opening on the lower side in the z direction is gradually enlarged be provided on a lower side of the hole of the floating guide 11 in the z direction.

The upper side of the floating guide 11 in the z direction is attached to the lower-side holding portion 21 by screwing. The first springs 13 are provided between the floating guide 11 and the lower-side holding portion 21. The first springs 13 bias the floating guide 11 away from the first flexible substrate 31a and the second flexible substrate 32a in the z direction. Therefore, the floating guide 11 and the lower-side holding portion 21 are maintained in a separated state by the first springs 13 unless a force is applied in a direction of contraction in the z direction, such as pushing the first inspection jig 1 into the inspection target connector 100 from the upper side in the z direction.

### Substrate Holding Portion 20

The substrate holding portion 20 includes the lower-side holding portion (pin block frame) 21 and an upper-side holding portion (connection plate) 23. The lower-side holding portion 21 is provided on the lower side of the substrate portion 30 in the z direction. The upper-side holding portion 23 is provided on the upper side of the substrate portion 30 in the z direction. The lower-side holding portion 21 and the upper-side holding portion 23 sandwich the substrate portion 30 in the z direction.

The lower-side holding portion 21 has a hole penetrating in the z direction. The lower end of the substrate portion 30 is inserted into the hole of the lower-side holding portion 21 from the upper side in the z direction. A convex portion is formed on the lower side of the lower-side holding portion 21 in the z direction. The convex portion is fitted into the hole of the floating guide 11 from the upper side in the z direction.

A front-side holding portion 31c of the front-side substrate assembly 31 and a rear-side holding portion 32c of the rear-side substrate assembly 32 are attached to the upper side of the lower-side holding portion 21 in the z direction. An attachment of the front-side holding portion 31c to the lower-side holding portion 21 is performed by fitting and bonding using a boss hole. An attachment of the rear-side holding portion 32c to the lower-side holding portion 21 is performed by bonding.

A front-side push block 31i of the front-side substrate assembly 31 and a rear-side push block 32i of the rear-side substrate assembly 32 are attached to the lower side of the upper-side holding portion 23 in the z direction. An attachment of the front-side push block 31i to the upper-side holding portion 23 is performed from the upper side in the z direction and by screwing that uses a round hole. An attachment of the rear-side push block 32i to the upper-side holding portion 23 is performed from the upper side in the z direction and by screwing that uses an elongated hole extending in the x direction. The elongated hole extending in the x direction of the upper-side holding portion 23 is used to adjust an interval in the x direction between the front-side holding portion 31c that holds the front-side push block 31i and the rear-side holding portion 32c that holds the rear-side push block 32i.

The interval in the x direction between the front-side holding portion 31c and the rear-side holding portion 32c is determined in accordance with an interval in the x direction between electrode positions of the inspection target connector 100. When the interval in the x direction between electrodes of the inspection target connector 100 is narrow, the attachments of the front-side holding portion 31c and the rear-side holding portion 32c to the lower-side holding portion 21, and the attachments of the front-side push block 31i and the rear-side push block 32i to the upper-side holding portion 23 are performed in a state where the interval in the x direction between the front-side holding portion 31c and the rear-side holding portion 32c is narrow. When the interval in the x direction between electrodes of the inspection target connector 100 is wide, the attachments of the front-side holding portion 31c and the rear-side holding portion 32c to the lower-side holding portion 21, and the attachments of the front-side push block 31i and the rear-side push block 32i to the upper-side holding portion 23 are performed in a state where the interval in the x direction between the front-side holding portion 31c and the rear-side holding portion 32c is wide.

That is, the substrate holding portion 20 holds a plurality of flexible substrates (first flexible substrate 31a and second flexible substrate 32a) in a state where the interval in the x direction is adjustable.

### Substrate Portion 30

The substrate portion 30 includes the front-side substrate assembly 31 and the rear-side substrate assembly 32. The front-side substrate assembly 31 is disposed on a front side in the x direction, and the rear-side substrate assembly 32 is disposed on a rear side in the x direction.

### Front-side Substrate Assembly 31

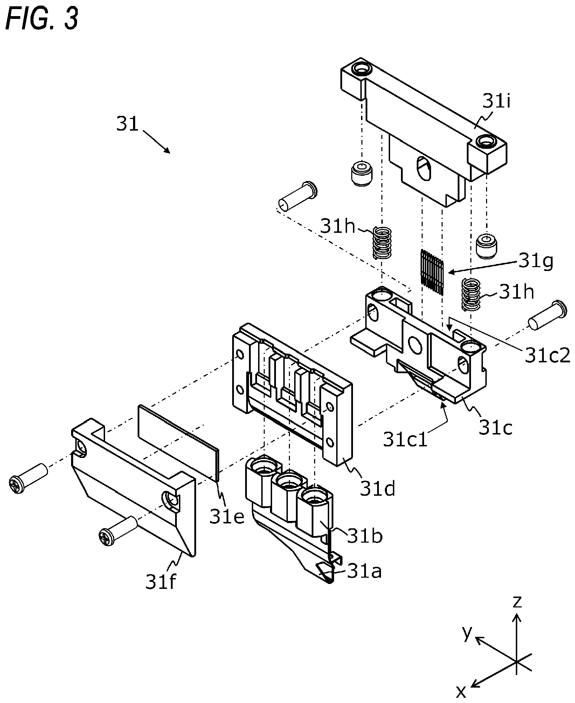

As illustrated in FIG. 3, the front-side substrate assembly 31 includes the first flexible substrate (flexible substrate) 31a, a first connector 31b, the front-side holding portion 31c, a front-side connector base 31d, a front-side connector presser rubber 31e, a front-side connector cover 31f, a front-side probe group 31g, front-side second springs 31h, and the front-side push block (second movable member) 31i.

### First Flexible Substrate 31a

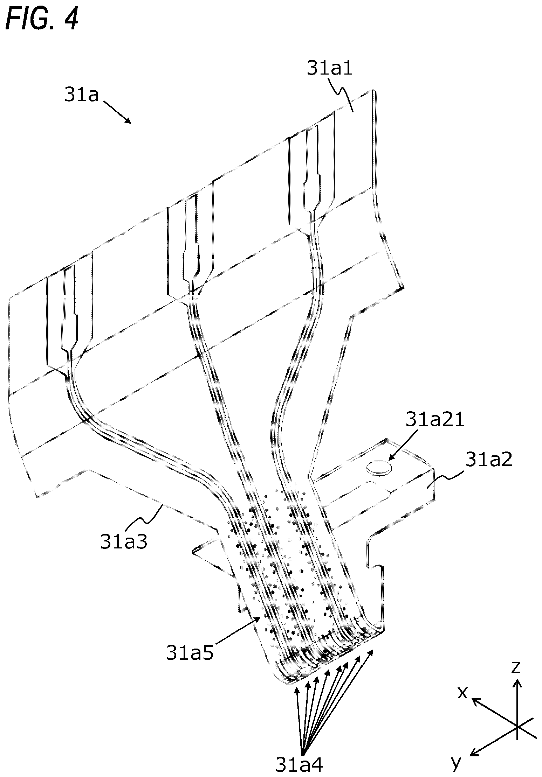

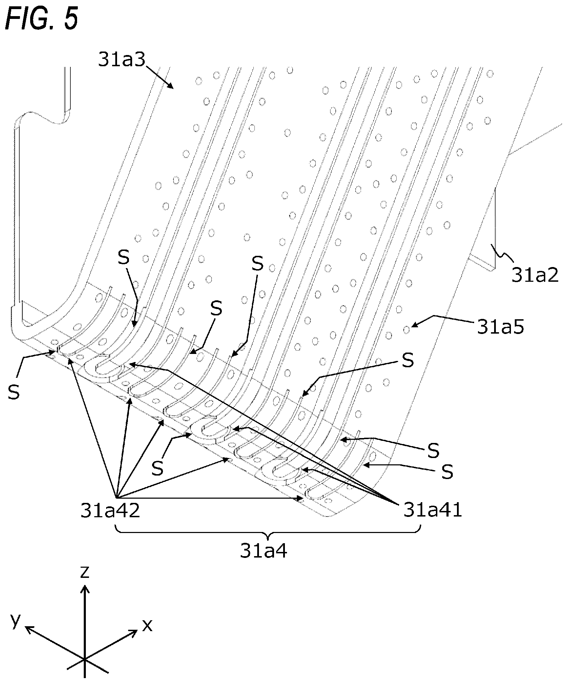

As illustrated in FIGS. 4 and 5, the first flexible substrate 31a includes a connector connection end (one end portion) 31a1, a holding portion connection end (the other end portion) 31a2, and a pattern portion 31a3.

The connector connection end 31a1 is an end portion of the first flexible substrate 31a on the front side in the x direction and on the upper side in the z direction. The first connector 31b is attached to the connector connection end 31a1 by soldering or the like. The holding portion connection end 31a2 is an end portion of the first flexible substrate 31a on the rear side in the x direction and on the upper side in the z direction, and is latched to the front-side holding portion 31c. Specifically, holes 31a21 provided in the holding portion connection end 31a2 are fitted into bosses 31c3 provided on the upper side of a probe receptacle 31c1 of the front-side holding portion 31c in the z direction. However, latching of the holding portion connection end 31a2 and the front-side holding portion 31c is not limited to fitting of the holes 31a21 and the bosses 31c3.

The pattern portion 31a3 is a region between the connector connection end 31a1 and the holding portion connection end 31a2. A pattern of a transmission line (any one of signal line, ground wire, or power line) extending from the connector connection end 31a1 and a ground wire is formed on a surface on the lower side (surface side) of the pattern portion 31a3 in the z direction. The pattern portion 31a3 is bent so as to have a substantially V shape when viewed from the y direction. On a surface on the lower side of the pattern portion 31a3 in the z direction, end portions of the transmission line are provided at a lower end portion that is in a state of being bent so as to have a substantially V shape. The end portions of the transmission line are used as a substrate-side electrode electrically connected to the electrode of the inspection target connector 100.

### Slits S and Tongue Pieces 31a4

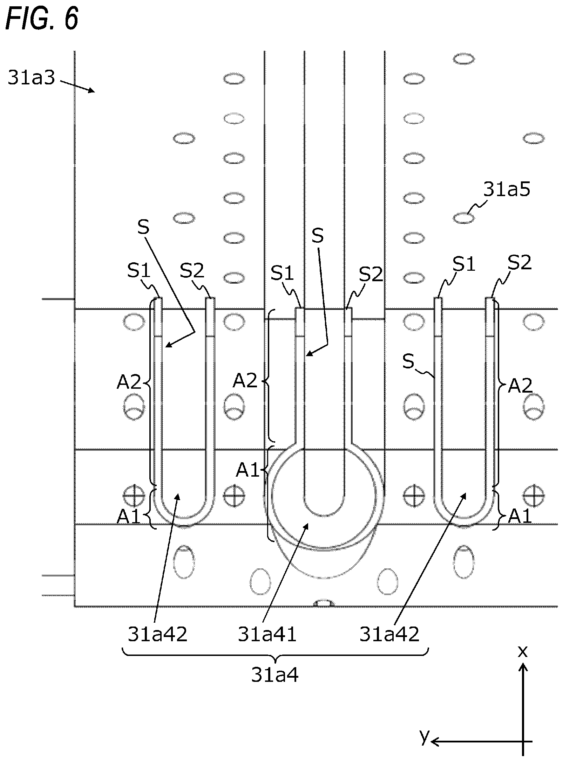

As illustrated in FIG. 6, slits S are provided around the end portions of the transmission line (region including a portion of the pattern portion 31a3 electrically connected to the inspection target connector 100). Each slit S has a start point S1 and an end point S2 on a side closer to the connector connection end 31a1 than the end portions of the transmission line. The start point S1 and the end point S2 are in a positional relation sandwiching the transmission line. The slit S extends along the transmission line from the start point S1 to the side where the end portions of the transmission line are present, further extends so as to surround the end portions of the transmission line, and further extends along the transmission line to the end point S2. Tongue pieces 31a4 having a substantially U shape are formed by the slits S. That is, the pattern portion 31a3 includes the tongue pieces 31a4. The slits S are notches (cuts) closed at both ends (the start point S1 and the end point S2), but one end (one of the start point S1 and the end point S2) may be an open end and the other end (the other of the start point S1 and the end point S2) may be a closed end.

### First Tongue Pieces 31a41 and Second Tongue Pieces 31a42

The tongue pieces 31a4 includes first tongue pieces 31a41 and second tongue pieces 31a42. Each of the first tongue pieces 31a41 and the second tongue pieces 31a42 has a first region (distal end region of the tongue piece) A1 and a second region (base region of the tongue piece) A2. The first region A1 is a region in which the end portions of the transmission line are present. Each of the first tongue pieces 31a41 and the second tongue pieces 31a42 is electrically connected to another member such as the inspection target connector 100 via the first region A1. The second region A2 communicates with the first region A1. The second region A2 is a region where the transmission line extends, and includes a start point S1 and an end point S2 of the slit S (end portion of the notch).

It is desirable that the first tongue pieces 31a41 are formed at the end portion of the signal line in the transmission line. Each first tongue piece 31a41 has a substantially U-shape including a wide region at a distal end portion thereof. The width of the first region A1 of the first tongue piece 31a41 is larger than the width of the second region A2 of the first tongue piece 31a41. Specifically, the first region A1 of the first tongue piece 31a41 has a region having a width (dimension in the y direction) larger than the second region A2 of the first tongue piece 31a41. That is, the first region A1 of the first tongue piece 31a41 has a shape gradually wider and then gradually narrower from the region in contact with the second region A2 of the first tongue piece 31a41 toward the distalmost portion.

The first region A1 of the first tongue piece 31a41 has both a region rapidly wider and a region rapidly narrower as compared with the second region A2 of the first tongue piece 31a41. Here, the "region rapidly wider as compared with the second region A2" is a region close to the second region A2 of the first region A1, and the "region rapidly narrower as compared with the second region A2" is the distalmost portion of the first region A1.

In the first embodiment, the second region A2 of the first tongue piece 31a41 has a substantially rectangular shape sandwiched by two slits S, and the first region A1 of the first tongue piece 31a41 has a substantially circular shape. For example, the rear side has a region wider than the front side, where the front side is defined as the second region A2 of the first tongue piece 31a41 and the rear side is defined as the first region A1 of the first tongue piece 31a41. That is, the first tongue piece 31a41 has a shape substantially rectangular at the front and circular at the rear. However, the first region A1 of the first tongue piece 31a41 is not limited to substantially circular, and may be, for example, polygonal.

The width of the wide region of the first region A1 of the first tongue piece 31a41 and the shape of the first region A1 are determined so as not to physically interfere with the adjacent slits or through holes. For example, the width of the wide region of the first region A1 of the first tongue piece 31a41 (if the first region A1 is circular, the diameter of the circle) is about twice the width of the second region A2 of the first tongue piece 31a41.

It is desirable that the second tongue pieces 31a42 are formed at the end portions of the ground wire and the power line in the transmission line. Each second tongue piece 31a42 has a substantially U-shape without a wide region at the distal end portion. The first region A1 of the second tongue piece 31a42 does not have a region wider than the second region A2 of the second tongue piece 31a42. That is, the first region A1 of the second tongue piece 31a42 has a shape gradually narrower from the region in contact with the second region A2 of the second tongue piece 31a42 toward the distalmost portion, without a wide region.

The first region A1 of the second tongue piece 31a42 has a region rapidly narrower as compared with the second region A2 of the second tongue piece 31a42. Here, the "region rapidly narrower as compared with the second region A2" is the distalmost portion of the first region A1.

Therefore, the wide region of the first region A1 of the second tongue piece 31a42 has the same width (dimension in the y direction) as the second region A2 of the second tongue piece 31a42. That is, the width of the first region A1 of the second tongue piece 31a42 is equal to or less than the width of the second region A2 of the second tongue piece 31a42.

In the first embodiment, the second region A2 of the second tongue piece 31a42 is sandwiched by two slits S and substantially rectangular, and the first region A1 of the second tongue piece 31a42 is substantially semicircular. However, the first region A1 of the second tongue piece 31a42 is not limited to substantially semicircular, and may be, for example, semi-polygonal.

The pattern provided on the surface on the lower side (surface side) of the pattern portion 31a3 in the z direction is not limited to transmission line. On the surface on the lower side (surface side) of the pattern portion 31a3 in the z direction, a plurality of through holes 31a5 and a ground wire may be provided only in a region (first region A1 of the tongue piece 31a4) to be connected to the inspection target connector 100 and a region of the connector connection end 31a1 where the first connector 31b is soldered. In this case, since a region where the ground wire is provided is reduced, the cost is reduced as compared with a case where the pattern of the ground wire is provided on an entire surface on the lower side (surface side) of the pattern portion 31a3 in the z direction.

In order to increase an amount of displacement to the lower side in the z direction by probes P of the front-side probe group 31g to be described later, it is desirable to increase a length in a longitudinal direction of the slits S forming a second region A2 of the tongue pieces 31a4. On the other hand, in order to prevent characteristics of the signal line in a high frequency region from being deteriorated, it is desirable to shorten the length in the longitudinal direction of the slits S forming the second regionA2 of the tongue pieces 31a4. Therefore, the length in the longitudinal direction of the slits S forming the second region A2 of the tongue pieces 31a4 is determined in consideration of the amount of displacement to the lower side in the z direction of the tongue pieces 31a4 and the characteristics of the signal line in the high frequency region. In each tongue piece 31a4, one signal line, one ground wire, or one power line may be provided alone, or at least one of the signal line, the ground wire, and the power line may be provided in plural.

The first tongue piece 31a41 formed by the slit S is not limited to a substantially U-shape having a wide region at the distal end portion. As long as the pattern portion 31a3 can be displaced from the upper side in the z direction to the lower side in the z direction by the probes P of the front-side probe group 31g in a state where the pattern portion 31a3 does not extend, the tongue piece 31a4 may have other shapes having a wide region at the distal end portion, such as a substantially groove shape.

The second tongue piece 31a42 formed by the slit S is not limited to the substantially U shape. As long as the pattern portion 31a3 can be displaced from the upper side in the z direction to the lower side in the z direction by the probes P of the front-side probe group 31g in a state where the pattern portion 31a3 does not extend, the tongue piece 31a4 may have other shapes such as a substantially V shape, a substantially C shape, a substantially L shape, and a substantially groove shape.

On a surface on the upper side (back side) of the pattern portion 31a3 in the z direction, that is, on a side opposite to a side electrically connected to the inspection target connector 100, a ground wire different from the ground wire on the surface on the lower side (surface side) in the z direction, or a ground plane is provided. In the pattern portion 31a3, a plurality of through holes 31a5 for electrically connecting the surface on the upper side in the z direction and the surface on the lower side in the z direction are provided. FIGS. 4 to 6 illustrate examples in which the plurality of through holes 31a5 are provided. However, an arrow line of a member number "31a5" indicates only one of the plurality of through holes 31a5.

In a case where a plurality of through holes 31a5 are provided in the pattern portion 31a3, even when another member is electrically connected only to one surface side (side electrically connected to another member: surface side) of the pattern portion 31a3, the other surface side (side opposite to the side electrically connected to the other member: back side) of the pattern portion 31a3 can be electrically connected to another member.

Depending on a specification of the inspection target connector 100, the ground wire or the ground plane on the surface on the upper side of the pattern portion 31a3 in the z direction and the plurality of through holes 31a5 may be omitted. In addition, in drawings other than FIGS. 4 to 6, illustrations of the transmission line of the pattern portion 31a3, the slits S, the tongue pieces 31a4, and the through holes 31a5 are omitted.

In addition, the plurality of through holes 31a5 and a grounded region (ground wire or ground plane) on the upper side (back side) in the z direction may be provided only in the region (first region A1 of the tongue piece 31a4) to be connected to the inspection target connector 100 and the region of the connector connection end 31a1 where the first connector 31b is soldered.

### First Connector 31b

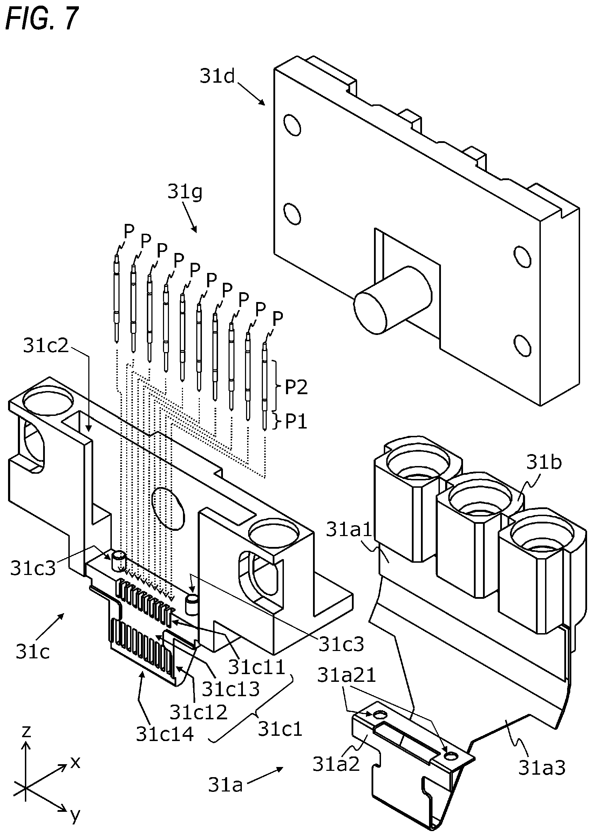

As illustrated in FIG. 7, the first connector 31b is attached to the connector connection end 31a1 of the first flexible substrate 31a. The first connector 31b is used for electrically connecting the first flexible substrate 31a to an inspection device (not illustrated).

### Front-side Holding Portion 31c

The front-side holding portion 31c holds the front-side connector base 31d on the front side in the x direction. The front-side holding portion 31c holds the holding portion connection end 31a2 of the first flexible substrate 31a on the rear side in the x direction.

### Probe Receptacle 31c1

On the rear side in the x direction and on the lower side in the z direction of the front-side holding portion 31c, a probe receptacle 3 1c1 that holds the front-side probe group 31g is provided. The probe receptacle 3 1c1 is formed of a resin material. When the probe receptacle 31c1 is formed of a resin material, the probe receptacle 31c 1 is lighter in weight, easier in processing, and less expensive than when the probe receptacle 31c1 is formed of a metal material. Incidentally, the probe receptacle 3 1c1 may be formed of a metal material.

The probe receptacle 3 1c1 includes grooves (upper groove portion 31c11 and lower groove portion 31c12) extending in the z direction and holes (upper hole portion 31c 13 and lower hole portion 31c 14) extending in the z direction. Widths of the upper groove portion 31c 11 and the lower groove portion 31c 12 in the x direction and the y direction are larger than an outer diameter of a spring accommodation portion (barrel) P2 of the probes P constituting the front-side probe group 31g. An upper end of the upper hole portion 31c13 communicates with a lower end of the upper groove portion 31 c 11, and a lower end of the upper hole portion 31c13 communicates with an upper end of the lower groove portion 31c12. An inner diameter of the upper hole portion 31c13 is larger than the outer diameter of the spring accommodation portion P2 of the probes P constituting the front-side probe group 31g. An upper end of the lower hole portion 31c14 communicates with a lower end of the lower groove portion 31c12, and a lower end of the lower hole portion 31c14 is open. An inner diameter of the lower hole portion 31c14 is larger than an outer diameter of a distal end portion P1 of the probes P constituting the front-side probe group 31g and smaller than the outer diameter of the spring accommodation portion P2.

### Method for Forming Probe Receptacle 3 1c1

The upper groove portion 31c11 and the lower groove portion 31c12 are formed by a metal mold. Holes of the upper hole portion 31c13 and the lower hole portion 31c14 are formed by punching holes in a rectangular parallelepiped region using pins or the like. However, the method for forming the probe receptacle 3 1c1 is not limited to the above-described method.

### Attachment of First Flexible Substrate 31a to Front-side Holding Portion 31c

The first flexible substrate 31a is attached to the front-side holding portion 31c so as to satisfy the following two conditions. First condition: the lower side of the front-side holding portion 31c in the z direction faces the surface on the upper side of the pattern portion 31a3 of the first flexible substrate 31a in the z direction. Second condition: the first region A1 of the tongue piece 31a4 of the first flexible substrate 31a is positioned on the lower side of the lower hole portion 31c14 of the probe receptacle 3 1c1 of the front-side holding portion 31c in the z direction.

### Push Block Groove Portion 31c2

A groove (push block groove portion 31c2) opened to the upper side in the z direction is provided on the upper side of the probe receptacle 3 1c1 of the front-side holding portion 31c in the z direction. The front-side push block 31i is inserted into the push block groove portion 31c2 from the upper side in the z direction (see FIG. 3).

### Boss 31c3

The bosses 31c3 extending upward in the z direction is provided on the upper side of the probe receptacle 31c1 of the front-side holding portion 31c in the z direction. The bosses 31c3 are used for latching the holding portion connection end 31a2 of the first flexible substrate 31a.

### Front-side Connector Base 31d

The front-side connector base 31d holds the first connector 31b on the front side in the x direction. The front-side connector base 31d is positioned on the front side in the x direction with respect to the front-side holding portion 31c, and is attached to the front-side holding portion 31c.

An assembly of the first flexible substrate 31a and the first connector 31b is attached to an assembly of the front-side holding portion 31c and the front-side connector base 31d so as to sandwich the front-side holding portion 31c and the front-side connector base 31d in the x direction and to wrap the lower end of the front-side holding portion 31c. An attachment of the front-side holding portion 31c to the front-side connector base 31d is performed by screwing from the rear side in the x direction.

### Front-side Connector Presser Rubber 31e

The front-side connector presser rubber 31e is provided between the first connector 31b and the front-side connector cover 31f. The front-side connector presser rubber 31e is used to minimize an adverse effect on electrical connection with the inspection device due to variations in height of the first connector 3 1b. The front-side connector presser rubber 31e is used to make the first connector 31b difficult to move when a cable extending from the inspection device is attached to or detached from the first connector 31b.

### Front-side Connector Cover 31f

The front-side connector cover 31f covers the pattern portion 31a3 of the first flexible substrate 31a and the front side of the first connector 3 1b in the x direction. An attachment of the front-side connector cover 31f to the front-side connector base 31d is performed by screwing from the front side in the x direction. The front-side connector cover 31f and the front-side connector base 31d sandwich the first connector 31b and the front-side connector presser rubber 31e in the x direction.

### Front-side Probe Group 31g

The front-side probe group 31g includes a plurality of probes (extendable members) P that extend and contract in the z direction. The plurality of probes P are arranged in the y direction. Each of the probes P constituting the front-side probe group 31g has the distal end portion P1 on the lower side in the z direction, and has the spring accommodation portion P2 on the upper side in the z direction with respect to the distal end portion P1. A spring (not illustrated) is accommodated in the spring accommodation portion P2. The distal end portion P1 is biased by the spring in the spring accommodation portion P2 in a direction in which an entire length of the distal end portion P1 extends.

When each of the probes P constituting the front-side probe group 31g is placed on the probe receptacle 31c1 of the front-side holding portion 31c in a state where the first flexible substrate 31a is not attached to the front-side holding portion 31c, the distal end portion P1 of the probes P protrudes toward the lower side in the z direction from the holes (lower hole portion 31c14) of the lower end portion of the probe receptacle 31c1. However, since the spring accommodation portion P2 is held by a step between the lower hole portion 31c14 and the lower groove portion 3 1c12, the probes P do not fall from the lower hole portion 31c14.

When each of the probes P constituting the front-side probe group 31g is placed on the probe receptacle 31c1 of the front-side holding portion 31c in a state where the first flexible substrate 31a is attached to the front-side holding portion 31c, the distal end portion P1 of the probes P comes into contact with the back side of the first region A1 of the tongue pieces 31a4 of the first flexible substrate 31a. For example, among the plurality of probes P, a first probe P is in a positional relation of being in contact with one of the regions of the first flexible substrate 31a electrically connected to the inspection target connector 100 (first region A1 of one of the tongue pieces 31a4). In addition, among the plurality of probes P, a second probe P different from the first probe P is in a positional relation of being in contact with one of the regions (one of the tongue pieces 31a4) of the first flexible substrate 31a electrically connected to the inspection target connector 100, that is, the first region A1 of a tongue piece 31a4 different from the tongue piece 31a4 corresponding to the first probe P. However, since the probe P is light, the probe P is only in contact with the tongue piece 31a4, and hardly displaces the tongue piece 31a4 to the lower side in the z direction.

An attachment of the assembly of the first flexible substrate 31a and the first connector 31b to the assembly of the front-side holding portion 31c and the front-side connector base 31d is performed in a state where each of the probes P constituting the front-side probe group 31g is placed on the probe receptacle 31c1.

### Front-side Second Spring 31h and Front-side Push Block 31i

The front-side push block 31i is inserted into the groove (push block groove portion 31c2) of the front-side holding portion 31c from the upper side in the z direction in a state where the front-side push block 3li is movable in the z direction. The front-side push block 3li is used to push down each of the probes P constituting the front-side probe group 31g toward the lower side in the z direction. That is, the plurality of probes P constituting the front-side probe group 31g are provided between the first flexible substrate 31a and the front-side push block 31i. The front-side second spring 31h is provided between the front-side holding portion 31c and the front-side push block 31i. The front-side second spring 31h biases the front-side push block 31i away from the front-side holding portion 31c in the z direction.

Spring characteristics (spring pressure, spring constant, and the like) of the first springs 13, the front-side second spring 31h, and a rear-side second spring 32h are set such that when a force is applied in the direction of contraction in the z direction, compressions of the front-side second spring 31h and the later-described rear-side second spring 32h in the z direction are completed after compression of the first springs 13 in the z direction is completed. That is, after the first springs 13 contract, the front-side second spring 31h and the rear-side second spring 32h contract.

That is, when the first flexible substrate 31a and the second flexible substrate 32a are connected to the inspection target connector 100, operations of the floating guide 11, the first flexible substrate 31a, and the second flexible substrate 32a are controlled by the first springs 13, the front-side second spring 31h, and the rear-side second spring 32h in the following manner. After a first distance d1 between the floating guide 11 and the first flexible substrate 31a and the second flexible substrate 32a is shortened, a second distance d2 between the front-side push block 31i and the first flexible substrate 31a is shortened, and at substantially the same timing, a second distance d2 between the rear-side push block 32i and the second flexible substrate 32a is shortened.

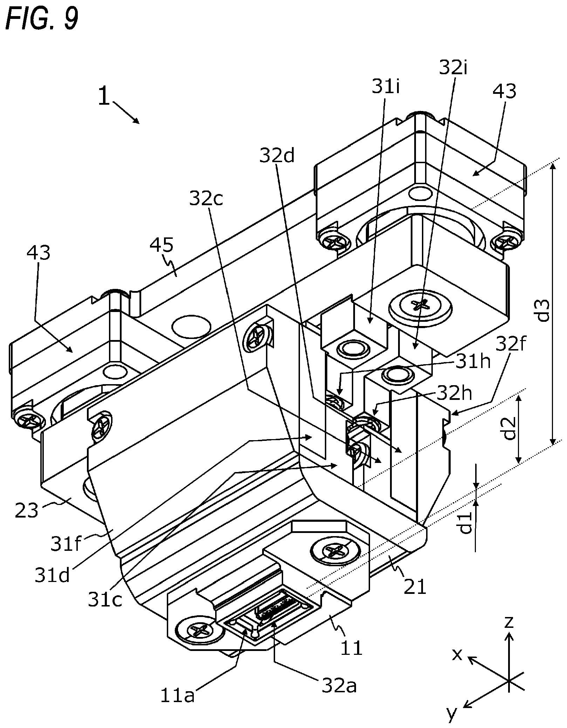

For example, the first distance d1 is a distance in the z direction between a lower end portion (opening region into which the inspection target connector 100 is inserted) of the floating guide 11 and a lower end portion (region of the pattern portion 31a3 electrically connected to the inspection target connector 100) of the first flexible substrate 31a. For example, the second distance d2 is a distance in the z direction between a lower end portion (region in contact with the front-side probe group 31g) of the front-side push block 31i and a lower end portion (region of the pattern portion 31a3 electrically connected to the inspection target connector 100) of the first flexible substrate 31a (see FIG. 9).

Therefore, even when a force is applied to the inspection target connector 100 in the direction of contraction in the z direction, such as pushing the first inspection jig 1 from the upper side in the z direction, the front-side push block 31i and the front-side holding portion 31c are maintained in a separated state by the front-side second spring 31h, and the rear-side push block 32i and the rear-side holding portion 32c are maintained in a separated state by the rear-side second spring 32h, as long as the first springs 13 do not contract.

### Rear-side Substrate Assembly 32

The rear-side substrate assembly 32 includes the second flexible substrate (flexible substrate) 32a, a second connector 32b, the rear-side holding portion 32c, a rear-side connector base 32d, a rear-side connector presser rubber 32e, a rear-side connector cover 32f, a rear-side probe group 32g, the rear-side second spring 32h, and the rear-side push block (second movable member) 32i.

A configuration of the rear-side substrate assembly 32 is the same as a configuration of the front-side substrate assembly 31 except that an orientation of the x direction is reversed. The second flexible substrate 32a of the rear-side substrate assembly 32 corresponds to the first flexible substrate 31a of the front-side substrate assembly 31. The second connector 32b of the rear-side substrate assembly 32 corresponds to the first connector 31b of the front-side substrate assembly 31. The rear-side holding portion 32c of the rear-side substrate assembly 32 corresponds to the front-side holding portion 31c of the front-side substrate assembly 31. The rear-side connector base 32d of the rear-side substrate assembly 32 corresponds to the front-side connector base 31d of the front-side substrate assembly 31. The rear-side connector presser rubber 32e of the rear-side substrate assembly 32 corresponds to the front-side connector presser rubber 31e of the front-side substrate assembly 31. The rear-side connector cover 32f of the rear-side substrate assembly 32 corresponds to the front-side connector cover 31f of the front-side substrate assembly 31. The rear-side probe group 32g of the rear-side substrate assembly 32 corresponds to the front-side probe group 31g of the front-side substrate assembly 31. The rear-side second spring 32h of the rear-side substrate assembly 32 corresponds to the front-side second spring 31h of the front-side substrate assembly 31. The rear-side push block 32i of the rear-side substrate assembly 32 corresponds to the front-side push block 31i of the front-side substrate assembly 31.

### Horizontal Position Adjusting Portion 40

The horizontal position adjusting portion 40 includes a third spring (third elastic member) 41, the support portion (third movable member) 43, and a bracket 45 (see FIG. 1).

### Third Spring 41 and Support Portion 43

Two support portions 43 are provided in the y direction. Each of the two support portions 43 incorporates a coil spring (not illustrated).

The support portion 43 is used to absorb a deviation from a position facing the electrodes of the inspection target connector 100 in the z direction regarding the first region A1 of the tongue piece 31a4 of the first flexible substrate 31a of the front-side substrate assembly 31 and the distal end region of the tongue piece of the second flexible substrate 32a of the rear-side substrate assembly 32.

For example, it is assumed that the first region A1 of the tongue piece 31a4 of the first flexible substrate 31a of the front-side substrate assembly 31 and the distal end region of the tongue piece of the second flexible substrate 32a of the rear-side substrate assembly 32 are deviated on an xy plane from the position facing the electrodes of the inspection target connector 100 in the z direction. In this case, when the first inspection jig 1 is attached to the inspection target connector 100, the connector contact portion 10, the substrate holding portion 20, and the substrate portion 30 can move on the xy plane without moving the horizontal position adjusting portion 40.

An attachment of the support portion 43 to the upper-side holding portion 23 is performed by screwing from the lower side in the z direction. The third spring 41 is provided between the support portion 43 and the upper-side holding portion 23. The third spring 41 biases the support portion 43 away from the upper-side holding portion 23 in the z direction.

Spring characteristics (spring pressure, spring constant, and the like) of the first springs 13, the front-side second spring 31h, the rear-side second spring 32h, and the third spring 41 are set such that when a force is applied in the direction of contraction in the z direction, compression of the third spring 41 in the z direction is completed after compressions of the first springs 13, the front-side second spring 31h, and the rear-side second spring 32h in the z direction are completed. That is, after the first springs 13, the front-side second spring 31h, and the rear-side second spring 32h contract, the third spring 41 contracts.

That is, when the first flexible substrate 31a and the second flexible substrate 32a are connected to the inspection target connector 100, operations of the floating guide 11, the front-side push block 31i, the rear-side push block 32i, and the support portion 43 are controlled by the first springs 13, the front-side second spring 31h, the rear-side second spring 32h, and the third spring 41 in the following manner. After the first distance d1 between the floating guide 11 and the first flexible substrate 31a and the second flexible substrate 32a is shortened, the second distance d2 between the front-side push block 31i and the first flexible substrate 31a is shortened, and at substantially the same timing, the second distance d2 between the rear-side push block 32i and the second flexible substrate 32a is shortened. After the second distance d2 between the front-side push block 31i and the first flexible substrate 31a is shortened and the second distance d2 between the rear-side push block 32i and the second flexible substrate 32a is shortened, a third distance d3 between the support portion 43 and the first flexible substrate 31a and the second flexible substrate 32a is shortened.

For example, the third distance d3 is a distance in the z direction between a lower end portion (region facing the upper-side holding portion 23 in the z direction) of the support portion 43 and the lower end portion (region of the pattern portion 31a3 electrically connected to the inspection target connector 100) of the first flexible substrate 31a.

Therefore, even when a force is applied to the inspection target connector 100 in the direction of contraction in the z direction, such as pushing the first inspection jig 1 from the upper side in the z direction, the support portion 43 and the upper-side holding portion 23 are maintained in a separated state by the third spring 41 as long as the first springs 13, the front-side second spring 31h, and the rear-side second spring 32h do not contract.

As an example of the spring characteristics, the spring characteristics of each spring may be set such that the spring pressure of the third spring 41 is higher than the spring pressures of the front-side second spring 31h and the rear-side second spring 32h, and the spring pressures of the front-side second spring 31h and the rear-side second spring 32h is higher than the spring pressure of the first spring 13.

In addition, as an example of the spring characteristics, the spring characteristics of each spring may be set such that a combined spring constant (elastic coefficient) of two third springs 41 is larger than a combined spring constant (elastic coefficient) of two front-side second springs 31h and two rear-side second springs 32h, and a combined spring constant (elastic coefficient) of two front-side second springs 31h and two rear-side second springs 32h is larger than a combined spring constant (elastic coefficient) of two first springs 13.

### Bracket 45

The bracket 45 is attached to a device (not illustrated) that holds and moves the first inspection jig 1, such as an inspection device or a machine tool. The bracket 45 is attached to the upper side of the two support portions 43 in the z direction. An attachment of the bracket 45 to the support portions 43 is performed by screwing from the upper side in the z direction.

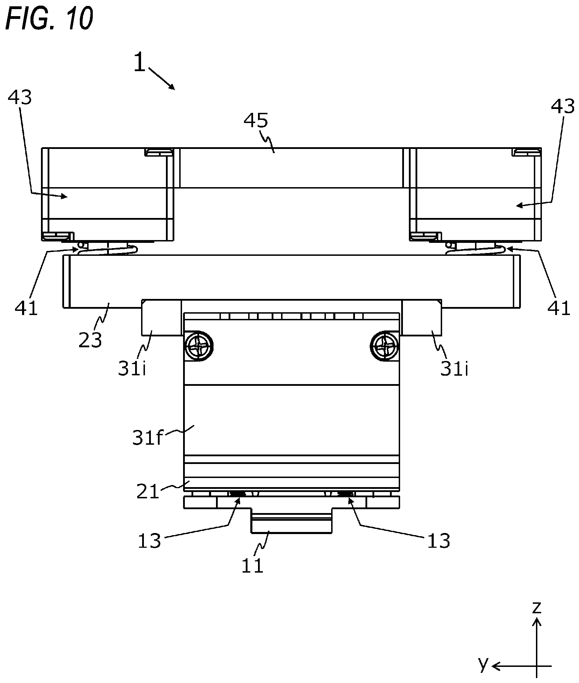

As illustrated in FIGS. 9 and 10, the first springs 13, the front-side second spring 31h, and the rear-side second spring 32h are disposed such that a part of the first springs 13 is visible from the outside, and such that the front-side second spring 31h and the rear-side second spring 32h are hardly visible from the outside (not visible from the front side in the x direction and the rear side in the x direction). In addition, the third spring 41 is disposed such that at least a part of the third spring 41 can be seen from the outside in an extended state.

### Material for Each Portion, Metal Component, and Resin Component

Among members constituting the first inspection jig 1, the front-side probe group 31g, the rear-side probe group 32g, screws, and conductive regions such as the first flexible substrate 31a are made of metal. Other members constituting the first inspection jig 1 are made of a non-conductive member such as a resin.

### Procedure of Connecting First Inspection Jig 1 to Inspection Target Connector 100

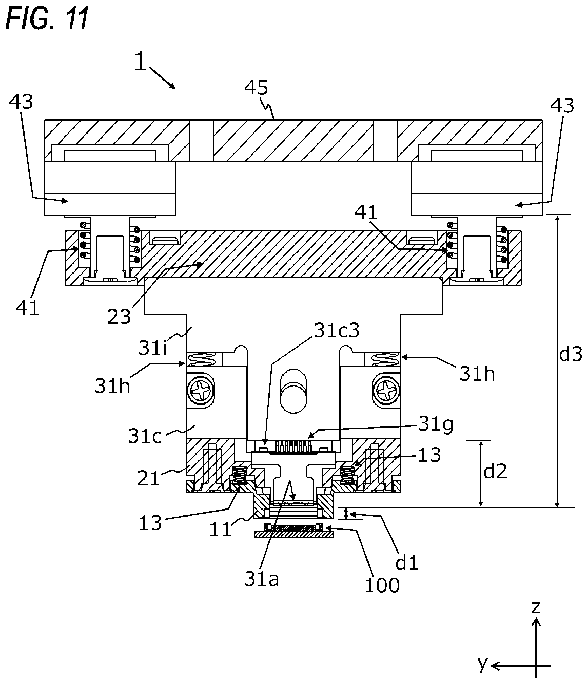

Next, a change in an extension/contraction state of the first springs 13 and the like when the first inspection jig 1 is moved from the upper side in the z direction to the lower side in the z direction to be connected to the inspection target connector 100 will be described (FIGS. 11 to 17).

The rear-side second spring 32h is not illustrated in yz cross-sectional configuration views of FIGS. 11, 13 to 15, and 17. However, the rear-side second spring 32h is positioned on the rear side of the front-side second spring 31h in the x direction, and extends and contracts in the same manner as the front-side second spring 31h. The rear-side push block 32i is not illustrated in the yz cross-sectional configuration views of FIGS. 11, 13 to 15, and 17. However, the rear-side push block 32i is positioned on the rear side of the front-side push block 31i in the x direction, and moves in the same manner as the front-side push block 31i. In addition, the rear-side probe group 32g is not illustrated in the yz cross-sectional configuration views of FIGS. 11, 13 to 15, and 17. However, the rear-side probe group 32g is positioned on the rear side of the front-side probe group 31g in the x direction, and operates in the same manner as the front-side probe group 31g. In addition, the tongue pieces of the second flexible substrate 32a are not illustrated. However, the tongue pieces of the second flexible substrate 32a are positioned on the rear side of the tongue pieces 31a4 of the first flexible substrate 31a in the x direction, and is displaced in the same manner as the tongue pieces 31a4 of the first flexible substrate 31a.

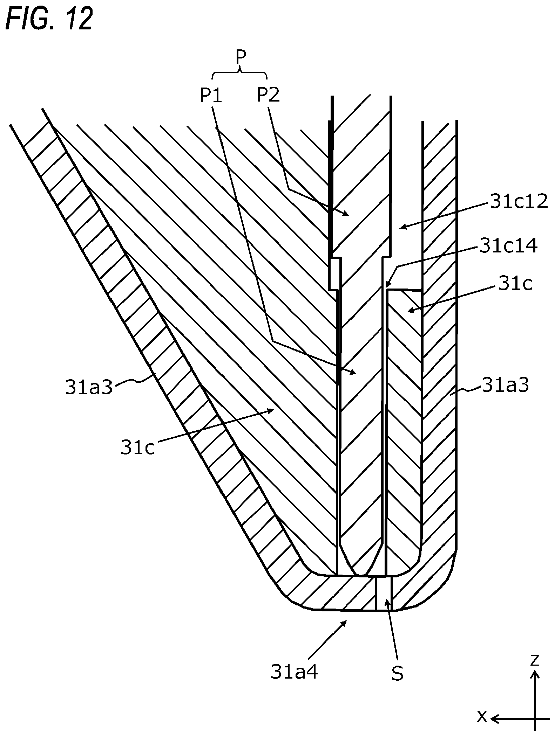

As illustrated in FIG. 11, before the first inspection jig 1 comes into contact with the inspection target connector 100, the first springs 13, the front-side second spring 31h, the rear-side second spring 32h, and the third spring 41 are in an extended state, and the first distance d1, the second distance d2, and the third distance d3 are not shortened (first state). In this case, the distal end portion P1 on the lower side of the probe P constituting the front-side probe group 31g in the z direction is in contact with the first region A1 of the tongue piece 31a4 of the first flexible substrate 31a (see FIG. 12). However, since the probe P is light, the tongue piece 31a4 of the first flexible substrate 31a is hardly pressed to the lower side in the z direction. Similarly, the distal end portion P1 on the lower side of the probe P constituting the rear-side probe group 32g in the z direction is in contact with the distal end region of the tongue piece of the second flexible substrate 32a. However, since the probe P is light, the tongue piece of the second flexible substrate 32a is hardly pressed to the lower side in the z direction.

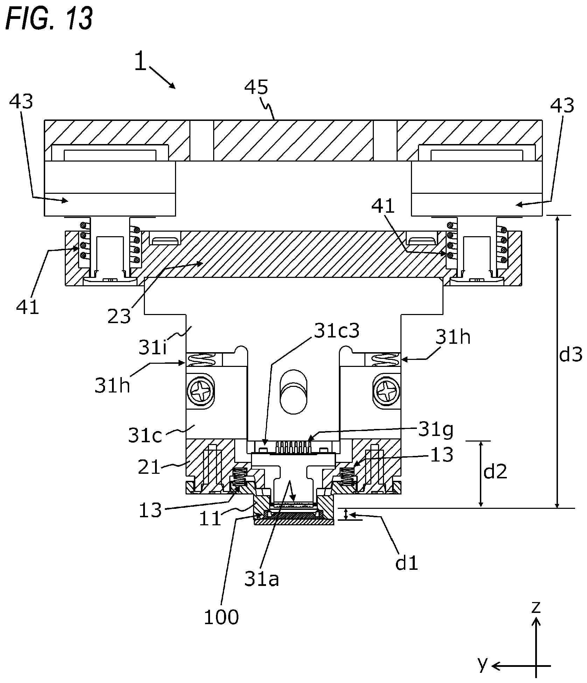

As illustrated in FIG. 13, immediately after the inspection target connector 100 is fitted into the holes of the floating guide 11 of the first inspection jig 1, the first springs 13, the front-side second spring 31h, the rear-side second spring 32h, and the third spring 41 are in an extended state, and the first distance d1, the second distance d2, and the third distance d3 are not shortened (second state). In this case, the first flexible substrate 31a and the second flexible substrate 32a are not in contact with the inspection target connector 100.

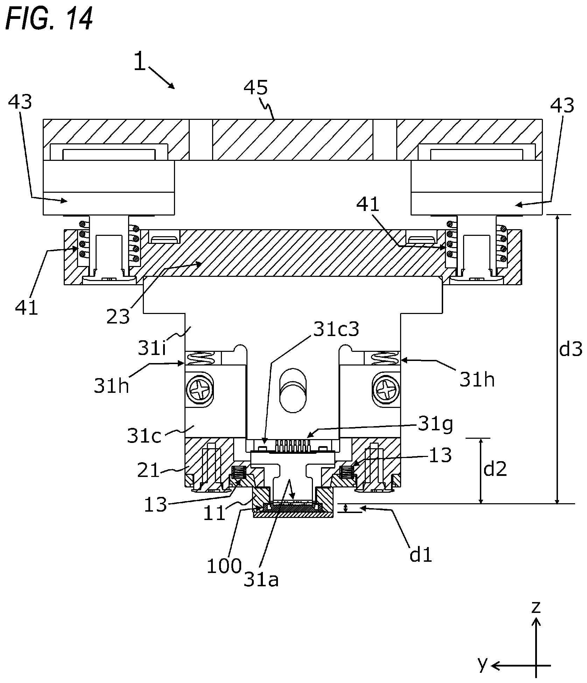

As illustrated in FIG. 14, when the first inspection jig 1 further moves to the lower side in the z direction from the second state, the first spring 13 contracts in the z direction, and the lower-side holding portion 21 is brought close to the floating guide 11 (third state).

In this case, the first flexible substrate 31a and the second flexible substrate 32a are in a state of being close to the inspection target connector 100. Therefore, the first distance d1 in the third state is shorter than the first distance d1 in the second state. However, the front-side second spring 31h, the rear-side second spring 32h, and the third spring 41 are hardly contracted. Therefore, the second distance d2 in the third state is hardly shorter than the second distance d2 in the second state. The third distance d3 in the third state is hardly shorter than the third distance d3 in the second state.

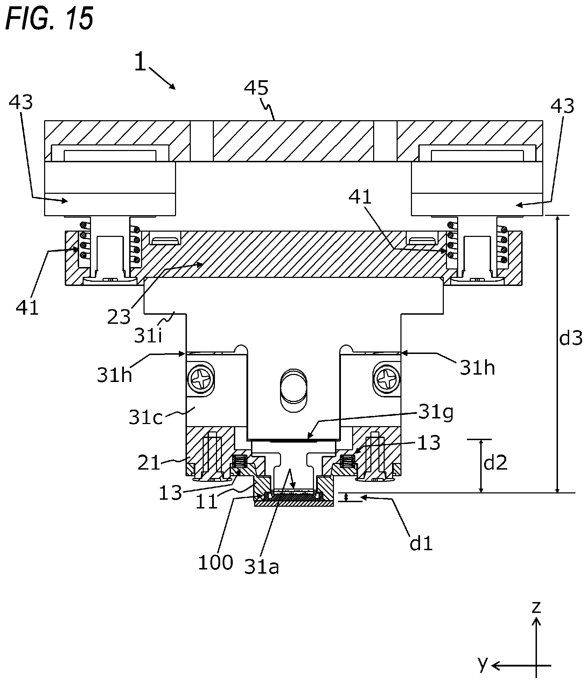

As illustrated in FIG. 15, when the first inspection jig 1 further moves to the lower side in the z direction from the third state, the front-side second spring 31h contracts in the z direction, and the front-side push block 31i is brought close to the front-side holding portion 31c (fourth state). Similarly, the rear-side second spring 32h contracts in the z direction, and the rear-side push block 32i is brought close to the rear-side holding portion 32c.

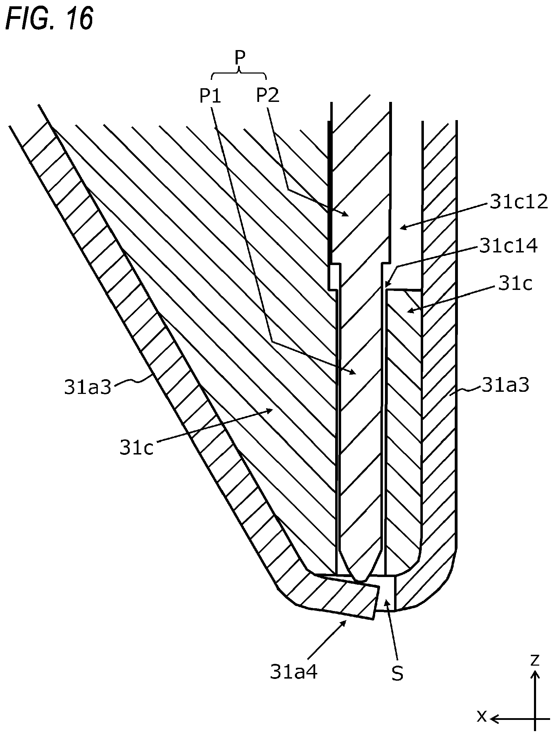

When the front-side push block 31i moves to the lower side in the z direction, the probes P of the front-side probe group 31g move to the lower side in the z direction, and the distal end portion P1 of the probes P pushes the back side (upper side in the z direction) of the first flexible substrate 31a. As a result, the tongue pieces 31a4 of the first flexible substrate 31a are pushed to the lower side in the z direction (see FIG. 16). That is, the first region A1 of the tongue pieces 31a4 of the first flexible substrate 31a are brought close to the electrode of the inspection target connector 100 by the probes P of the front-side probe group 31g. Similarly, when the rear-side push block 32i moves to the lower side in the z direction, the probes P of the rear-side probe group 32g move to the lower side in the z direction, and the distal end portions P1 of the probes P push the back side (upper side in the z direction) of the second flexible substrate 32a. As a result, the tongue pieces of the second flexible substrate 32a are pushed to the lower side in the z direction. That is, the distal end region of the tongue pieces of the second flexible substrate 32a are brought close to the electrode of the inspection target connector 100 by the probes P of the rear-side probe group 32g.

As a result, the first flexible substrate 31a and the second flexible substrate 32a are in a state of being electrically connected to the inspection target connector 100. The first distance d1 in the fourth state is further shorter than the first distance d1 in the third state. In addition, the front-side push block 31i and the rear-side push block 32i are pushed down to the lowermost end of a movable range in the z direction. Therefore, the second distance d2 in the fourth state is shorter than the second distance d2 in the third state. However, the third spring 41 is hardly contracted. Therefore, the third distance d3 in the fourth state is hardly shorter than the third distance d3 in the third state.

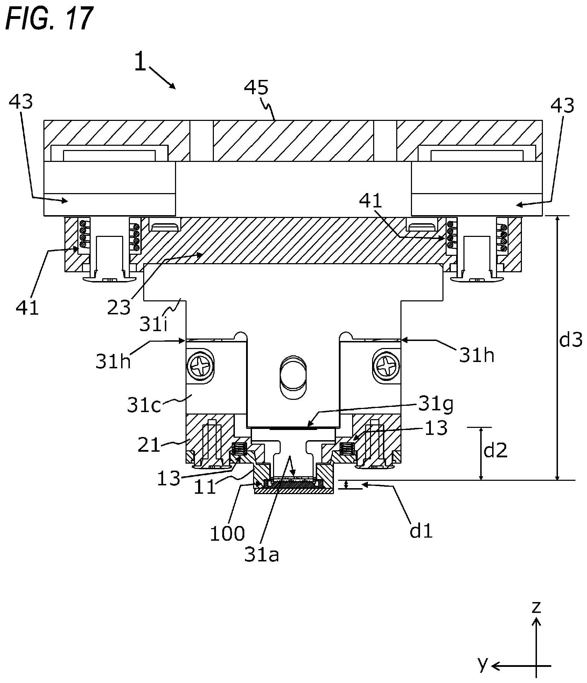

As illustrated in FIG. 17, when the first inspection jig 1 further moves to the lower side in the z direction from the fourth state, the third spring 41 contracts in the z direction, and the support portion 43 and the bracket 45 are brought close to the upper-side holding portion 23 (fifth state). In this case, the support portion 43 is in a state of being close to the upper-side holding portion 23. Therefore, the third distance d3 in the fifth state is shorter than the third distance d3 in the fourth state.

Whether the front-side second spring 31h and the rear-side second spring 32h are in a contracted state cannot be visually recognized from the front side in the x direction and the rear side in the x direction. In addition, whether the front-side push block 31i and the rear-side push block 32i have moved to the lower side in the z direction cannot be visually recognized from the front side in the x direction and the rear side in the x direction. However, a part of the third spring 41 can be visually recognized from the outside at least in the extended state. Therefore, by observing a region where the third spring 41 is present from the outside, it is possible to confirm whether the third spring 41 starts to contract greatly, that is, whether a movement of the front-side push block 31i and the like to the lower side in the z direction is completed and the first flexible substrate 31a and the second flexible substrate 32a are in a state of being electrically connected to the inspection target connector 100.

### Effect of Individually Performing Pressing with Probe P

In consideration of variations in height of portions (electrodes) of the transmission line that are in contact with the inspection target connector 100, it is possible to reliably connect the respective electrodes to the inspection target connector 100 by individually pressing an extendable member such as the probe P against each electrode.

### Effect of Providing Tongue Piece on First Flexible Substrate 31a and Second Flexible Substrate 32a

In order to absorb the variations in height of the electrodes, when the extendable member such as the probe P is pressed and a force is partially applied, the tongue pieces 31a4 of the first flexible substrate 31a formed in a region including a portion to which the force is applied are separated from another region adjacent to the tongue pieces 31a4 of the first flexible substrate 31a via the slit S, and are displaced in the pressed direction (lower side in the z direction). In addition, the tongue pieces of the second flexible substrate 32a formed in the region including the portion to which the force is applied are separated from another region adjacent to the tongue pieces of the second flexible substrate 32a via the slit S, and are displaced in the pressed direction (lower side in the z direction). Therefore, as compared with a case where the tongue pieces are not provided, the flexible substrates (first flexible substrate 31a and second flexible substrate 32a) are less likely to be damaged even when displaced.

### Effect of Including Plurality of Electrodes in One Tongue Piece

Since the number of the slits S can be reduced as compared with a mode in which only one electrode is provided in one tongue piece 31a4, the tongue pieces 31a4 can be easily formed in a narrow region or the like. The same applies to the tongue pieces of the second flexible substrate 32a.

### Effect of Increase in Width of Distal End of Tongue Piece

If the width (dimension in the y direction) of the tongue pieces (the tongue pieces 31a4 of the first flexible substrate 31a and the tongue pieces of the second flexible substrate 32a corresponding to the first tongue pieces 31a41) is narrow, the following advantages are obtained as compared with the case where the width of the tongue pieces is wide. The weight of the tongue pieces can be reduced, and the tongue pieces can be displaced with a small load. If the load for displacing the tongue pieces can be reduced, the total load applied to the first inspection jig 1 is also reduced, the load applied to the components constituting the first inspection jig 1 is reduced, the deformation of the components is reduced, and the product life of the first inspection jig 1 can be extended.

If the tongue pieces are wide, the following advantages are obtained compared to the case where the tongue pieces are narrow. Since the tongue pieces are wide, an allowable amount of the positional deviation from the probe P is increased, and it is unnecessary to increase the accuracy of the alignment between the probe P and the tongue pieces, which facilitates the processing and reduces the manufacturing cost of the first inspection jig 1.

In the first embodiment, the width of the distal end region (first regionAl) of the first tongue piece 31a41, that is, the region of the first tongue piece 31a41 in contact with the probe P is larger than the width of the base region (second region A2) of the first tongue piece 31a41. The base region (second region A2) of the first tongue piece 31a41 is narrower than the distal end region (first region A1) of the first tongue piece 3 1a41. Accordingly, it is possible to increase the allowable amount of positional deviation from the probe P by increasing the contact region with the probe P, while reducing the weight of the tongue piece. Accordingly, it is possible to extend the product life of the first inspection jig 1 and reduce the manufacturing cost.

### Effect of Forming First Tongue Piece 31a41 Rectangular at Front and Circular at Rear

By forming the first region A1 in a substantially circular shape and the second region A2 in a substantially rectangular shape (a rectangular shape having substantially the same angle of the four corners), it is possible to easily form the first tongue piece 31a41 as compared with a configuration formed in another shape. Further, the distance from the end portions of the transmission line to the edge portion of the first region A1 can be made uniform, whereby the contact region with the probe P can be as large as possible and the allowable amount of positional deviation from the probe P can be as large as possible.

### Effect of Width of Wide Region of First Region A1 of First Tongue Piece 31a41 being Twice Width of Second Region A2

The first region A1 can be easily formed without physical interference with the adjacent slits S or through holes 31a5.

### Effect of Providing First Tongue Pieces 31a41 and Second Tongue Pieces 31a42

It is possible to provide the first tongue pieces 31a41 at the end portion of the transmission line where the allowable amount of positional deviation from the probe P is set large (signal line), and to provide the second tongue pieces 31a42 at the end portion of the transmission line where it is less necessary to set a large allowable amount (ground wire and power line).

### Effect of Using End Portion as Electrode

When electrical connection with another member is performed in the middle of the signal line, a portion between the connection portion and the end portion may function as an antenna to perform reception and transmission of noise. By performing electrical connection with another member in the vicinity of the end portion, it is possible to reduce the reception and transmission of noise. When electrical connection with another member is performed in the middle of the ground wire, impedance matching may collapse.

### Other Embodiments: Extendable Members Other than Probe

In the first embodiment, a mode is described in which the probe P is used as an extendable member that presses the first flexible substrate 31a from the back side (upper side in the z direction) to the lower side in the z direction and an extendable member that presses the second flexible substrate 32a from the back side (upper side in the z direction) to the lower side in the z direction. However, the extendable member is not limited to the probe P, and other elastic members may be used as long as the member is extendable in the z direction (direction of pressing the flexible substrate).

### Other Embodiments: Not Limited to Two Rows of Probes

In the first embodiment, a mode is described in which the front-side probe group 31g and the rear-side probe group 32g are arranged in the x direction, that is, the probe group arranged in the y direction is arranged in two rows in the x direction. However, the number of rows of the probe group may be one row or three or more rows in accordance with arrangement of the electrodes of the inspection target connector 100. For example, in a second inspection jig 2 described later, the probe group is provided in one row. In a third inspection jig 3 described later, the probe group is provided at four positions. In a fourth inspection jig 4 described later, the probe group is provided in ten rows.

### Other Embodiments: Elastic Members Other than Spring

In the first embodiment, a mode is described in which the first springs 13 are provided between the floating guide 11 and the lower-side holding portion 21, the front-side second spring 31h is provided between the front-side holding portion 31c and the front-side push block 31i, the rear-side second spring 32h is provided between the rear-side holding portion 32c and the rear-side push block 32i, and the third spring 41 is provided between the upper-side holding portion 23 and the support portion 43. However, the extendable member is not limited to the spring, and other elastic members may be used as long as the member is extendable in the z direction (direction of pressing the flexible substrate).

### Other Embodiments: Application Examples of Inspection Jig Using Flexible Substrate Containing Tongue Pieces

In the first embodiment, an example is described in which the flexible substrate (the first flexible substrate 31a or the like) including the first tongue pieces 31a41 is pressed via the extendable member such as the probe P to be connected to the inspection target connector 100 positioned on the opposite side to the extendable member. However, the flexible substrate including the first tongue pieces 31a41 may be used for connection to another inspection target member. In addition, the inspection jig including the flexible substrate having the first tongue pieces 31a41 is not limited to the first inspection jig 1, and may be an inspection jig configured in another shape.

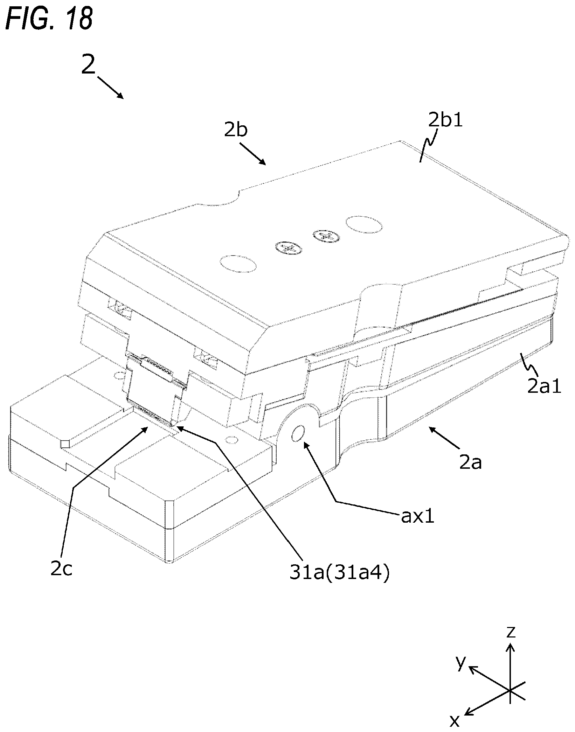

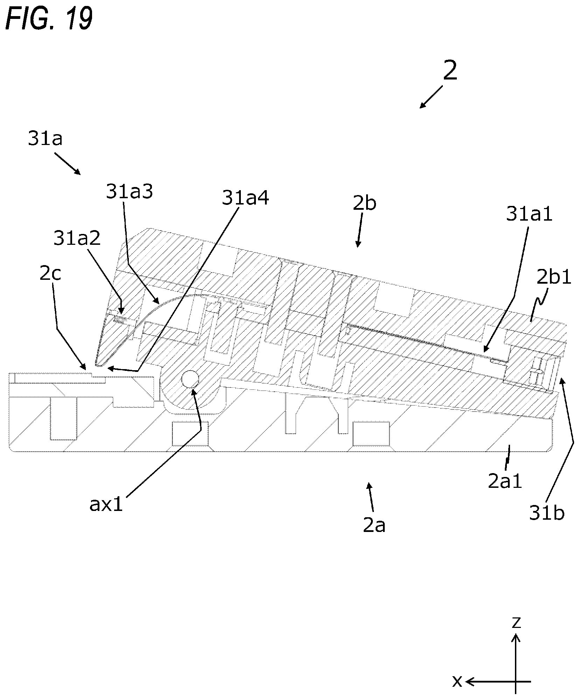

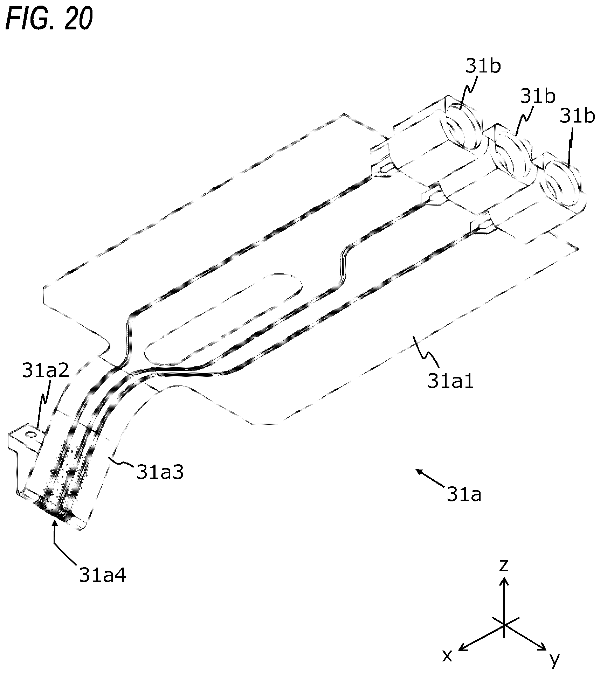

For example, the second inspection jig 2 may include a flexible substrate (first flexible substrate 31a) (second embodiment, see FIGS. 18 to 20). The second inspection jig 2 includes a first clip member 2a, a second clip member 2b, a base portion 2c, a first flexible substrate 31a, and a first connector 31b.

In order to describe the directions, a horizontal direction (front-rear direction) perpendicular to the rotation axis (first rotation axis ax1) of the second clip member 2b is defined as an x direction, a direction (left-right direction) parallel to the first rotation axis ax1 is defined as a y direction, and a direction (up-down direction) perpendicular to the x direction and the y direction is defined as a z direction. In FIG. 18, directions indicated by respective arrows of xyz axes are defined as a forward direction, a rightward direction, and an upward direction, respectively. Specifically, a direction from the first gripping region 2a1 of the first clip member 2a toward a region holding the base portion 2c of the first clip member 2a is defined as a forward direction. In FIG. 18, a direction from a region of the first clip member 2a located at the lower right on the front side in the x direction toward a region of the first clip member 2a located at the upper left on the front side in the x direction is defined as a rightward direction. A direction from the first clip member 2a toward the second clip member 2b is defined as an upward direction.

The first clip member 2a holds the second clip member 2b in a state of being rotatable about the first rotation axis ax1. The first clip member 2a has a base portion 2c. The second clip member 2b holds the first flexible substrate 31a and the first connector 31b. The second clip member 2b functions as a substrate holding portion 20. An extendable member (not shown) such as a probe is provided on the upper side in the z direction of the tongue pieces 31a4 of the first flexible substrate 31a. The base portion 2c holds an inspection target member (not shown).

When a force is applied such that the first gripping region 2a1 of the first clip member 2a and the second gripping region 2b1 of the second clip member 2b approach each other, a gap is generated between the tongue pieces 31a4 of the first flexible substrate 31a and the base portion 2c. The inspection target member is inserted into the gap, so that the inspection target member is placed on the base portion 2c. When the force applied such that the first gripping region 2a1 and the second gripping region 2b1 approach each other is released, the tongue pieces 31a4 of the first flexible substrate 31a come into contact with the inspection target member placed on the base portion 2c. At this time, the extendable member pushes the tongue pieces 31a4 downward in the z direction, and the end portions of the transmission line provided in the tongue pieces 31a4 are electrically connected to the inspection target member.

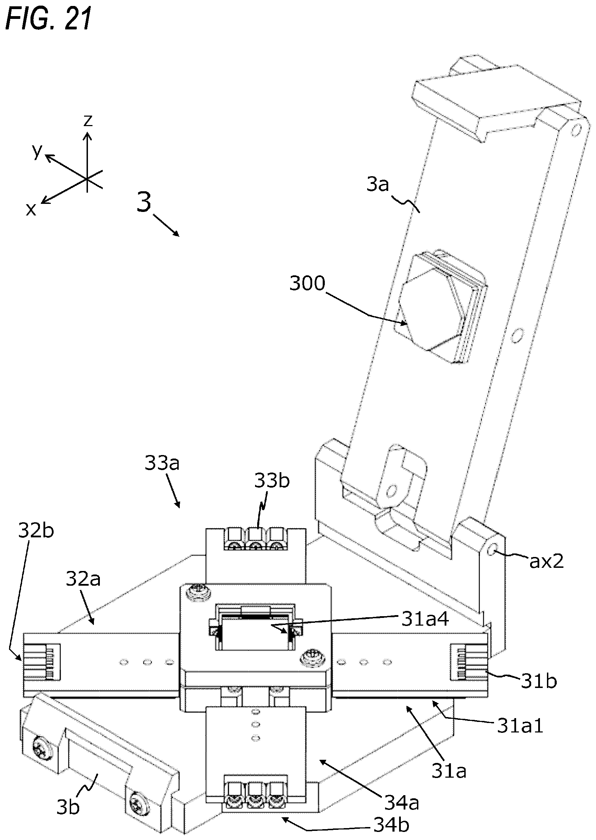

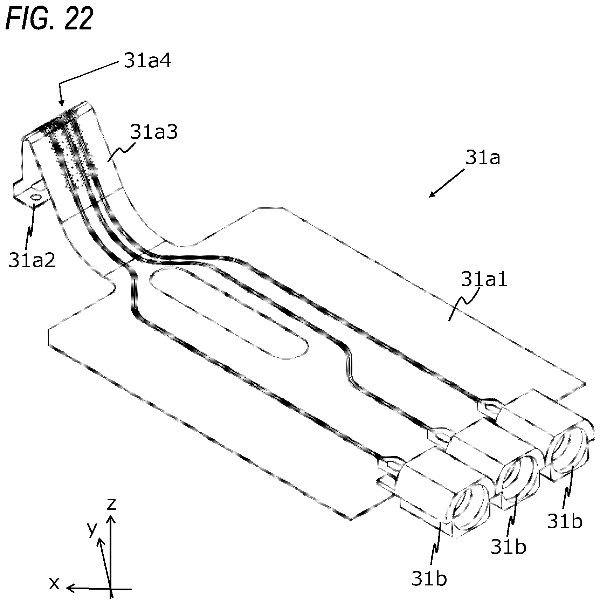

For example, the third inspection jig 3 may include a flexible substrate (the first flexible substrate 31a or the like) (see the third embodiment and FIGS. 21 to 22). The third inspection jig 3 includes a first pressing portion 3a, a first substrate holding table 3b, a first flexible substrate 31a to a fourth flexible substrate 34a, and first connector 31b to the fourth connector 34b.

In order to describe the directions, a horizontal direction (front-rear direction) perpendicular to the rotation axis (second rotation axis ax2) of the first pressing portion 3a is defined as an x direction, a direction (left-right direction) parallel to the second rotation axis ax2 is defined as a y direction, and a direction (up-down direction) perpendicular to the x direction and the y direction is defined as a z direction. In FIG. 21, directions indicated by respective arrows of xyz axes are defined as a forward direction, a rightward direction, and an upward direction, respectively. Specifically, a direction from a region of the first substrate holding table 3b holding the first pressing portion 3a toward a region of the first substrate holding table 3b where the distal end portion of the first pressing portion 3a is detachably attached is defined as a forward direction. Further, in FIG. 21, a direction from a region of the first substrate holding table 3b located at the lower right on the front side in the x direction toward a region of the first substrate holding table 3b located at the upper left on the front side in the x direction is defined as a rightward direction. In addition, a direction from the first substrate holding table 3b toward the first pressing portion 3a in a state where the distal end portion of the first pressing portion 3a is attached to the first substrate holding table 3b is defined as an upward direction.

The first pressing portion 3a holds the inspection target member (inspection target module 300). The first substrate holding table 3b holds the first pressing portion 3a in a state of being rotatable about the second rotation axis ax2. The first substrate holding table 3b holds the flexible substrates (the first flexible substrate 31a to the fourth flexible substrate 34a). The first substrate holding table 3b functions as a substrate holding portion 20. An extendable member (not shown) such as a probe is provided on the lower side in the z direction of the tongue pieces 31a4 of the first flexible substrate 31a. The configurations of the second flexible substrate 32a to the fourth flexible substrate 34a are the same as the configuration of the first flexible substrate 31a. The configurations of the second connector 32b to the fourth connector 34b are the same as those of the first connector 31b. An extendable member (not shown) such as a probe is provided on the lower side in the z direction of the tongue pieces in each of the second flexible substrate 32a to the fourth flexible substrate to 34a. The first flexible substrate 31a to the fourth flexible substrate 34a are arranged such that a region including the tongue pieces 31a4 of the first flexible substrate 31a, a region including the tongue pieces of the second flexible substrate 32a, a region including the tongue pieces of the third flexible substrate 33a, and a region including the tongue pieces of the fourth flexible substrate 34a are positioned on the sides forming a substantially square shape when viewed from the above in the z direction.

When the distal end portion of the first pressing portion 3a is brought close to the first substrate holding table 3b, the tongue pieces 31a4 of the first flexible substrate 31a and the tongue pieces of the second flexible substrate 32a to the fourth flexible substrate 34a come into contact with the inspection target module 300. At this time, the extendable member pushes the tongue pieces 31a4 or the like upward in the z direction, and the end portions of the transmission line provided in the tongue pieces 31a4 or the like are electrically connected to the inspection target module 300.

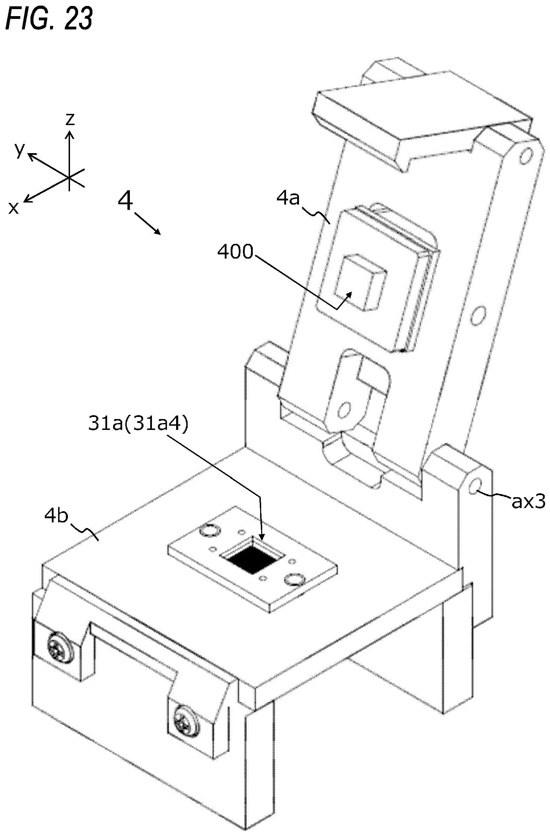

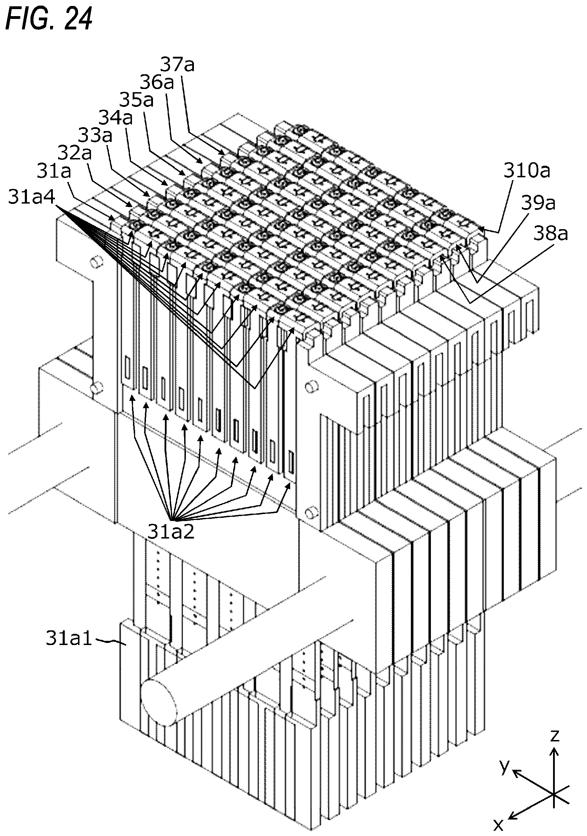

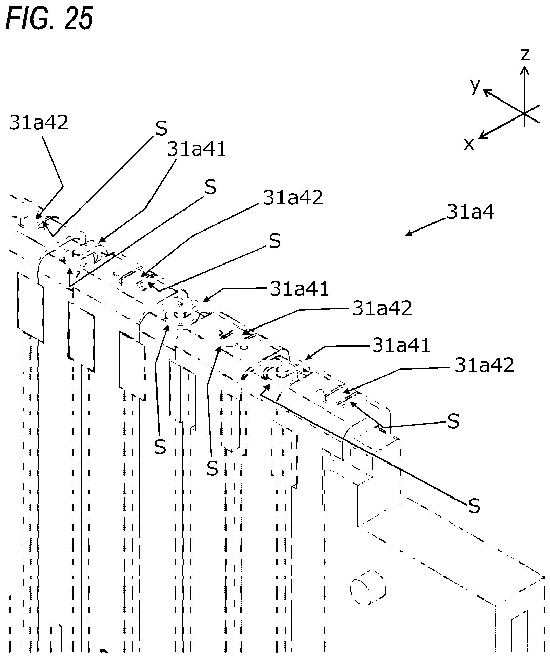

In addition, for example, the fourth inspection jig 4 may include a flexible substrate (the first flexible substrate 31a or the like) (see the fourth embodiment and FIGS. 23 to 25). The fourth inspection jig 4 includes a second pressing portion 4a, a second substrate holding table 4b, and a flexible substrate (such as the first flexible substrate 31a). The flexible substrates of the fourth inspection jig 4 include a first flexible substrate 31a, a second flexible substrate 32a, a third flexible substrate 33a, a fourth flexible substrate 34a, a fifth flexible substrate 35a, a sixth flexible substrate 36a, a seventh flexible substrate 37a, an eighth flexible substrate 38a, a ninth flexible substrate 39a, and a tenth flexible substrate 310a.

In order to describe the directions, a horizontal direction (front-rear direction) perpendicular to the rotation axis (third rotation axis ax3) of the second pressing portion 4a is defined as an x direction, a direction (left-right direction) parallel to the third rotation axis ax3 is defined as a y direction, and a direction (up-down direction) perpendicular to the x direction and the y direction is defined as a z direction. In FIG. 23, directions indicated by respective arrows of xyz axes are defined as a forward direction, a rightward direction, and an upward direction, respectively. Specifically, a direction from a region of the second substrate holding table 4b where the second pressing portion 4a is held toward a region of the second substrate holding table 4b where the distal end portion of the second pressing portion 4a is detachably attached is defined as a forward direction. In FIG. 23, a direction from a region of the second substrate holding table 4b located at the lower right on the front side in the x direction toward a region of the second substrate holding table 4b located at the upper left on the front side in the x direction is defined as a rightward direction. In addition, a direction from the second substrate holding table 4b toward the second pressing portion 4a in a state where the distal end portion of the second pressing portion 4a is attached to the second substrate holding table 4b is defined as an upward direction.

The second pressing portion 4a holds an inspection target member (BGA/LGA (ball grid array / land grid array) 400). The second substrate holding table 4b holds the second pressing portion 4a in a state of being rotatable about the third rotation axis ax3. The second substrate holding table 4b holds a flexible substrate such as the first flexible substrate 31a. The second substrate holding table 4b functions as the substrate holding portion 20. An extendable member (not shown) such as a probe is provided on the lower side in the z direction of the tongue pieces 31a4 of the first flexible substrate 31a. The connector connection end 31a1 of the first flexible substrate 31a is electrically connected to an inspection device (not shown) via a connector (not shown). The configurations of the second flexible substrate 32a to the tenth flexible substrate 310a are the same as those of the first flexible substrate 31a. The first flexible substrate 31a to the tenth flexible substrate 310a are arranged such that a region including the tongue pieces 31a4 (the first tongue pieces 31a41 and the second tongue pieces 31a42) of the first flexible substrate 31a, a region including the tongue pieces of the second flexible substrate 32a, a region including the tongue pieces of the third flexible substrate 33a, a region including the tongue pieces of the fourth flexible substrate 34a, a region including the tongue pieces of the fifth flexible substrate 35a, a region including the sixth flexible substrate 36a, a region including the seventh flexible substrate 37a, a region including the eighth flexible substrate 38a, a region including the ninth flexible substrate 39a, and a region including the tenth flexible substrate 310a are aligned in one direction when viewed from above in the z direction.

When the distal end portion of the second pressing portion 4a is brought close to the second substrate holding table 4b, the tongue pieces 31a4 of the first flexible substrate 31a and the tongue pieces of the second flexible substrate 32a to the tenth flexible substrate 310a come into contact with the BGA/LGA 400. At this time, the extendable member pushes the tongue pieces 31a4 or the like upward in the z direction, and the end portions of the transmission line provided in the tongue pieces 31a4 or the like are electrically connected to the BGA/LGA 400.

While certain embodiments are described, these embodiments are presented by way of examples only, and are not intended to limit the scope of the present invention. These embodiments can be implemented by various other forms, and various omissions, replacements, and modifications can be made without departing from the gist of the invention. These embodiments and modifications thereof are included in the scope of the invention or the gist of the invention, and are included in a scope equivalent to the invention described in the claims.

According to the present specification, the following aspects are provided.

### (Aspect 1)

A flexible substrate includes one end portion, the other end portion, and a pattern portion formed at least between the one end portion and the other end portion. The pattern portion includes a first tongue piece formed by a notch. The first tongue piece includes a first region which is a distal end region of the first tongue piece and a second region which is a base region of the first tongue piece and communicates with the first region. The first tongue piece is electrically connected to another member via the first region. A width of the first region is larger than a width of the second region.

According to Aspect 1, in a case where an extendable member such as a probe is pressed and a force is partially applied, a first tongue piece of the flexible substrate formed in a region including a portion to which the force is applied is separated from another region adjacent to the first tongue piece of the flexible substrate via a notch, and is displaced in the pressed direction. Therefore, as compared with a case where the first tongue piece is not provided, the flexible substrate is less likely to be damaged even when a force is partially applied. Further, the width of the distal end region (first region) of the first tongue piece, that is, the region of the first tongue piece in contact with the extendable member, is made wider than the base region (second region) of the first tongue piece. Accordingly, it is possible to increase the allowable amount of positional deviation from the extendable member by increasing the contact region with the extendable member while reducing the weight of the tongue piece.

### (Aspect 2)

Preferably, the first region is circular and the second region is rectangular.

According to aspect 2, by forming the first region in a circular shape and the second region in a rectangular shape, it is possible to easily form the first tongue piece as compared with a configuration formed in another shape. Further, the distance from the end portions of the transmission line to the edge portion of the first region can be made uniform, whereby the contact region with the extendable member can be as large as possible, and the allowable amount of positional deviation from the extendable member can be as large as possible.

### (Aspect 3)

More preferably, the pattern portion includes a second tongue piece. A width of a distal end region of the second tongue piece is equal to or less than a width of a base region of the second tongue piece.

According to aspect 3, it is possible to provide the first tongue piece at the end portion of the transmission line where the allowable amount of positional deviation from the extendable member is set large, and to provide the second tongue piece at the end portion of the transmission line where it is less necessary to set a large allowable amount.

### (Aspect 4)

More preferably, the pattern portion includes a signal line, a ground wire, and a power line, the signal line is formed with the first tongue piece, and the ground wire and the power line are formed with the second tongue piece.

According to aspect 4, it is possible to provide the first tongue piece at the end portion of the signal line where the allowable amount of positional deviation from the extendable member is set large, and to provide the second tongue piece at the end portions of the ground wire and the power line where it is less necessary to set a large allowable amount.

### (Aspect 5)

More preferably, the inspection jig includes the flexible substrate according to any one of aspects 1 to 4 and an extendable member. When the extendable member presses the back side of the region including the portion electrically connected to said another member, the tongue piece is electrically connected to said another member.

According to aspect 5, it is possible to extend the product life of the inspection jig and reduce the manufacturing cost.

### (Aspect 6)

More preferably, the second region of the first tongue piece is rectangular. The width of the wide region of the first region of the first tongue piece is twice the width of the second region of the first tongue piece.

According to aspect 6, the first region can be easily formed without physical interference with the adjacent notches or through holes.

### REFERENCE SIGNS LIST

1: first inspection jig
2: second inspection jig
2a: first clip member
2a1: first gripping region
2b: second clip member
2b1: second gripping region
2c: base portion
3: third inspection jig
3a: first pressing portion
3b: first substrate holding table
4: fourth inspection jig
4a: second pressing portion
4b: second substrate holding table
10: connector contact portion
11: floating guide (first movable member)
11a: guide portion
13: first spring (first elastic member)
20: substrate holding portion
21: lower-side holding portion (pin block frame)
23: upper-side holding portion (connection plate)
30: substrate portion
31: front-side substrate assembly
31a: first flexible substrate (flexible substrate)
31a1: connector connection end
31a2: holding portion connection end
31a21: hole
31a3: pattern portion
31a4: tongue piece
31a5: through hole
31b: first connector
31c: front-side holding portion
3 1c1: probe receptacle
31c11: upper groove portion
31c12: lower groove portion
31c13: upper hole portion
31c14: lower hole portion
31c2: push block groove portion
31c3: boss
31d: front-side connector base
31e: front-side connector presser rubber
31f: front-side connector cover
31g: front-side probe group
31h: front-side second spring (second elastic member)
31i: front-side push block (second movable member)
32: rear-side substrate assembly
32a: second flexible substrate (flexible substrate)
32b: second connector
32c: rear-side holding portion
32d: rear-side connector base
32e: rear-side connector presser rubber
32f: rear-side connector cover
32g: rear-side probe group
32h: rear-side second spring (second elastic member)
32i: rear-side push block (second movable member)
33a: third flexible substrate (flexible substrate)
33b: third connector
34a: fourth flexible substrate (flexible substrate)
34b: fourth connector
35a: fifth flexible substrate (flexible substrate)
36a: sixth flexible substrate (flexible substrate)
37a: seventh flexible substrate (flexible substrate)
38a: eighth flexible substrate (flexible substrate)
39a: ninth flexible substrate (flexible substrate)
310a: tenth flexible substrate (flexible substrate)
40: horizontal position adjusting portion
41: third spring
43: support portion
45: bracket
100: inspection target connector (inspection target member)
300: inspection target module (inspection target member)
400: BGA/LGA
ax1: first rotation axis
ax2: second rotation axis
ax3: third rotation axis
d1: first distance
d2: second distance
d3: third distance
P: probe (extendable member)
P1: distal end portion
P2: spring accommodation portion
S: slit

## Claims

1. A flexible substrate, comprising:
one end portion;
the other end portion; and
a pattern portion formed at least between the one end portion and the other end portion, wherein
the pattern portion includes a first tongue piece formed by a notch,
the first tongue piece includes a first region which is a distal end region of the first tongue piece and a second region which is a base region of the first tongue piece and communicates with the first region,
the first tongue piece is electrically connected to another member via the first region, and
a width of the first region is larger than a width of the second region.

2. The flexible substrate according to claim 1, wherein
the first region is circular and the second region is rectangular.

3. The flexible substrate according to claim 1, wherein
the pattern portion includes a second tongue piece, and
a width of a distal end region of the second tongue piece is equal to or less than a width of a base region of the second tongue piece.

4. The flexible substrate according to claim 3, wherein
the pattern portion includes a signal line, a ground wire, and a power line,
the signal line is formed with the first tongue piece, and
the ground wire and the power line are formed with the second tongue piece.

5. An inspection jig, comprising:
the flexible substrate according to any one of claims 1 to 4; and
an extendable member, wherein
the extendable member presses a back side of a region including a portion electrically connected to said another member, whereby the tongue piece is electrically connected to said another member.
